# EUROPEAN PATENT SPECIFICATION

(11) **EP 2 948 783 B1**
(45) Date of publication and mention of the grant of the patent: **14.04.2021**
(21) Application number: 14743295.9
(22) Date of filing: 23.01.2014
(51) Int. Cl.: G01R 27/26

(54) **CAPACITIVE WIRE SENSING FOR FURNITURE**
ERFASSUNG MIT EINEM KAPAZITIVEN DRAHT FÜR MÖBEL
DÉTECTION PAR FIL CAPACITIF POUR MOBILIER

(30) Priority: 24.01.2013 US 201313749120
(43) Date of publication of application: 02.12.2015
(73) Proprietor: L&P Property Management Company, South Gate, CA 90280 (US)
(72) Inventor: CHACON, Ryan, Edward, Carthage, MO 64836 (US); MADADI, Avinash, Webb City, MO 64870 (US); ROHR, William, Joplin, MO 64801 (US); CASSELL, Samantha, Chetopa, KS 67336 (US)
(74) Representative: Banzer, Hans-Jörg
(86) International application number: PCT/US2014/012797
(87) International publication number: WO 2014/116863

(56) References cited:
- EP-A1- 1 275 328
- WO-A1-02/11585
- WO-A1-99/44179
- DE-U1- 9 300 438
- US-A- 3 372 319
- US-A- 3 991 746
- US-A- 5 235 319
- US-A- 5 260 666
- US-A1- 2005 088 264
- US-A1- 2006 164 254
- US-A1- 2009 119 841
- US-A1- 2009 211 818
- US-A1- 2011 209 287
- US-A1- 2011 221 459

## Description

### FIELD OF THE INVENTION

The present invention generally relates to presence-sensing technology incorporated into an adjustable bed. More particularly, the invention relates to incorporating a conductive medium into the periphery of an adjustable bed for detecting the presence of a user or other body.

### BACKGROUND OF THE INVENTION

A variety of features may be integrated into automated bedding systems, including those designed to raise, lower, and generally conform to the comfort specifications of a user. Such automation may also include enhanced features that detect the presence of a person or other body, and elicit the corresponding automated response, such as stopping bed articulation or operating lighting in response to presence detection. For example, presence-sensing technology may be used to stop bed articulation to prevent an unintentional "pinch point," if the automated bedding system would otherwise be unaware of a person's presence.

Traditional presence-sensing technology for automated bedding systems utilize sensing or switches routed around the perimeter of a mattress. However, such switches can be expensive or impractical from a manufacturing standpoint. For example, presence-sensing switches may shift or bend during bed articulation, causing inaccurate readings and misplacement of the sensors. In applying upholstery to an adjustable bed, a switch may already be compressed if the upholstery is pulled too tight. Pressure pads and switches may also be problematic in presence detection when a switch fails to be triggered by a person' s presence. Alternatively, the same switches may be too sensitive, and activate independently from a body's presence. Additional analog components are required for presence detection in traditional technologies, using sensors/oscillators in addition to a circuit that detects a change.

Accordingly, a need exists for a reliable presence-sensing technology for use with an automated bedding system, which addresses the foregoing and other problems.

EP 1 275 328 A1 discloses an adjustable bed comprising a mattress support having a plurality of support panels which are movable relative to one another to thereby adjust the bed, and a mattress resting on top of the mattress support and having a covering material disposed over a top surface of the mattress. The adjustable bed comprises a capacitive switch which is actuated when a person touches the framework of the adjustable bed.

WO 99/44179 A1 and DE 93 00 438 U1 disclose other capacitive presence detection systems for beds.

### SUMMARY OF THE INVENTION

According to the invention, an adjustable bed as defined in claim 1 and a method for detecting presence with respect to an adjustable bed as defined in claim 7 are provided. The dependent claims define preferred and/or advantageous embodiments of the invention.

Additional objects, advantages, and novel features of the invention will be set forth in part in the description which follows, and in part will become apparent to those skilled in the art upon examination of the following, or may be learned by practice of the invention.

### BRIEF DESCRIPTION OF THE DRAWING

The present invention is described in detail below with reference to the attached drawing figures, wherein:
FIG. 1 is a top view of a capacitive wire coupled to the panels of an automated bed platform, in accordance with embodiments of the invention;
FIG. 2 is a bottom view of the automated bed platform of FIG. 1, with a capacitive wire and a control enclosure coupled to the panels, in accordance with embodiments of the invention;
FIG. 3 is a side view of the automated bed platform of FIG. 1, with a capacitive wire coupled to the top and bottom of the platform, and the control enclosure coupled to the bottom of the platform, in accordance with embodiments of the invention;
FIG. 4 is a perspective view of an automated bed with a portion of the mattress cut away to reveal the capacitive wire coupled to the top of the platform, in accordance with embodiments of the invention;
FIG. 5 is a perspective view of the automated bed of FIG. 4, with the mattress cut away to reveal the capacitive wire coupled to the top of the platform, and hidden lines indicating the capacitive wire and control enclosure coupled to the bottom of the platform, in accordance with embodiments of the invention;
FIG. 6 is an enlarged, perspective view of the automated bed of FIG. 5, with a capacitive wire coupled to the top of the platform and hidden lines indicating the capacitive wire and control enclosure coupled to the bottom of the platform, in accordance with embodiments of the invention;
FIG. 7 is a perspective view of an automated bed with a capacitive wire incorporated into the tape edge of the mattress cover, in accordance with embodiments of the invention;
FIG. 8 is a side view of a capacitive wire coupled to a control enclosure and an inner spring of a mattress, in accordance with embodiments of the invention;
FIG. 9 is a flow diagram of an exemplary method of detecting presence with respect to a bed, in accordance with embodiments of the invention;
FIG. 10 is a flow diagram of an exemplary method of detecting presence with respect to a bed, in accordance with embodiments of the invention;
FIG. 11 is a side view of foil tape and capacitive wire for application to a substrate, in accordance with embodiments of the invention;
FIG. 12 is a side view of foil tape having an embedded capacitive wire for application to a substrate; in accordance with embodiments of the invention;
FIG. 13 is a perspective view of a foil tape having an embedded capacitive wire, applied to an edge of a substrate, in accordance with embodiments of the invention;
FIG. 14 is a perspective view of a foil tape applied to an edge of a substrate, in accordance with embodiments of the invention;
FIG. 15 is a perspective view of a foil tape applied to multiple edges of a substrate, in accordance with embodiments of the invention;
FIG. 16 is a rear perspective view of an adjustable bed, in accordance with embodiments of the invention;
FIG. 17A is a conductive bushing, in accordance with embodiments of the invention;
FIG. 17B is a conductive encapsulating torque tube, in accordance with embodiments of the invention;
FIG. 17C is a conductive bushing, in accordance with embodiments of the invention;
FIG. 18 is a perspective view of an automated bed with head and feet portions of the bed raised to partially reveal a metal, adjustable bed frame, and a portion of the mattress cut away to reveal capacitive wire coupled to the top of the platform, in accordance with embodiments of the invention;
FIG. 19 is a perspective view of the automated bed of FIG. 18, with head and feet portions of the bed raised to partially reveal a metal, adjustable bed frame, and with the mattress cut away to reveal a capacitive wire coupled to the top of the platform and hidden lines indicating the capacitive wire and control enclosure coupled to the bottom of the platform, in accordance with embodiments of the invention;
FIG. 20 is an enlarged, perspective view of the automated bed of FIG. 19, with head and feet portions of the bed raised to partially reveal a metal, adjustable bed frame, and with a capacitive wire coupled to the top of the platform and hidden lines indicating the capacitive wire and control enclosure coupled to the bottom of the platform, in accordance with embodiments of the invention;
FIG. 21 is a perspective view of an automated bed with head and feet portions of the bed raised to partially reveal a metal, adjustable bed frame, and a tape edge surrounding a perimeter of the mattress cover, in accordance with embodiments of the invention;
FIG. 22 is an exemplary graphical display of the measure of head wire sense detection and foot wire sense detection associated with an adjustable bed, using capacitance monitoring, in accordance with embodiments of the invention;
FIG. 23 is an exemplary graphical display of the measure of contact detection with a metal, adjustable bed frame using capacitance monitoring, in accordance with embodiments of the invention; and
FIG. 24 is an exemplary graphical display of the measure of the rate of change of monitored capacitance during lowering of the head portion and foot portion of a metal, adjustable bed frame, in accordance with embodiments of the invention.

### DETAILED DESCRIPTION OF THE INVENTION

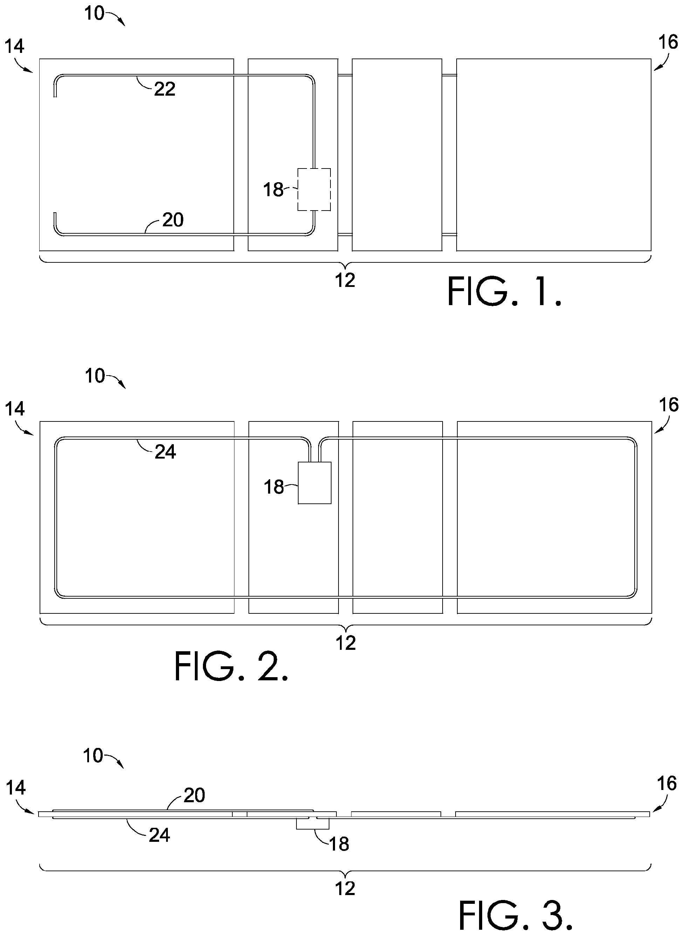

An embodiment of an automated bedding system 10 with capacitive wire sensing is seen in FIGS. 1-6. Referring first to FIG. 1, a top view of the platform of the automated bedding system 10 includes a plurality of panels 12 having a first end 14 and a second end 16, a control enclosure 18 (mounted below the panels 12), a first segment 20 of a capacitive wire, and a second segment 22 of a capacitive wire. In some embodiments, the first end 14 may be referred to as the "head" of the bed, while the second end 16 may be referred to as the "foot" of the bed.

When viewed from the top in FIG. 1, capacitive wiring is generally arranged near the first end 14 of the automated bedding system 10. A capacitive component, such as a capacitive wire, is adapted to have a voltage based on proximity of an object to the capacitive component. In some embodiments, the capacitive wire segments are standard conductive copper wires. The capacitance measured across such wires may be monitored by a processor that uses software to generate a determination of presence detection. In one embodiment, the Microchip® brand capacitive sensor may be used to determine when presence is detected. As such, while presence detection relies on the juxtaposition of a person or body with respect to the capacitive wiring, a determination of the level of detection or the measurement of presence is conducted digitally, in software associated with the processor.

As shown in FIG. 1, the capacitive wiring first and second segments 20 and 22 are coupled to the control enclosure 18, which is mounted below the panels 12 of the bedding system 10. In some embodiments, first and second segments 20 and 22 are made from a single capacitive wire, while in other embodiments, two separate capacitive wire segments 20 and 22 are coupled to the control enclosure 18. As will be understood, additional capacitive components, such as capacitive wire segments, may be coupled to the control enclosure 18, and arranged on the top of the plurality of panels 12. For example, additional capacitive wires arranged perpendicular to each other may be coupled to the control enclosure 18. In further embodiments, first and second segments 20 and 22 are made from a capacitive material other than wire.

Capacitive wire segments 20 and 22 may be used to detect presence or absence of a person or other being on top of the automated bedding system 10. For example, as arranged near first end 14 of the automated bedding system 10, the torso of a person positioned on the top of the automated bedding system 10 may be detected by capacitive wire segments 20 and 22. In embodiments, capacitive wire segments 20 and 22 create a defined sensing area on the top half of the head of the bedding system 10, and are less susceptible to noise interference from articulation of the rest of the automated bedding system 10.

Referring next to FIG. 2, a bottom view of the platform of the automated bedding system 10 includes the plurality of panels 12 having a first end 14 and a second end 16, a control enclosure 18, and a third segment 24 of capacitive wire. As shown in FIG. 2, the capacitive wiring third segment 24 is coupled to the control enclosure 18, which is mounted below the panels 12. In further embodiments, the control enclosure may be mounted in a different location on the bedding system 10, or may be external to the bedding system 10.

In some embodiments, third segment 24 is made from a single capacitive wire, while in other embodiments, multiple capacitive wire segments are coupled to the control enclosure 18. As will be understood, additional capacitive components, such as capacitive wire segments, may be coupled to the control enclosure 18, and arranged on the bottom of the plurality of panels 12. For example, additional capacitive wires arranged perpendicular to each other may be coupled to the control enclosure 18. In further embodiments, third segment 24 is made from a capacitive material other than wire.

Capacitive wire segment 24 may be used to detect presence or absence of a person or other being below the automated bedding system 10. For example, as arranged around the perimeter of the bed at both the first and second ends 14 and 16, a person or other body underneath the automated bedding system 10 may be detected by capacitive wire segment 24. In embodiments, based on detecting presence underneath the bedding system 10, bed articulation may be stopped. As viewed from the side in FIG. 3, the first and second segments 20 and 22 (hidden from view) create a defined sensing area on the top of the platform, near the first end 14, while the third segment 24 creates a defined sensing area on the bottom of the platform of the bedding system 10.

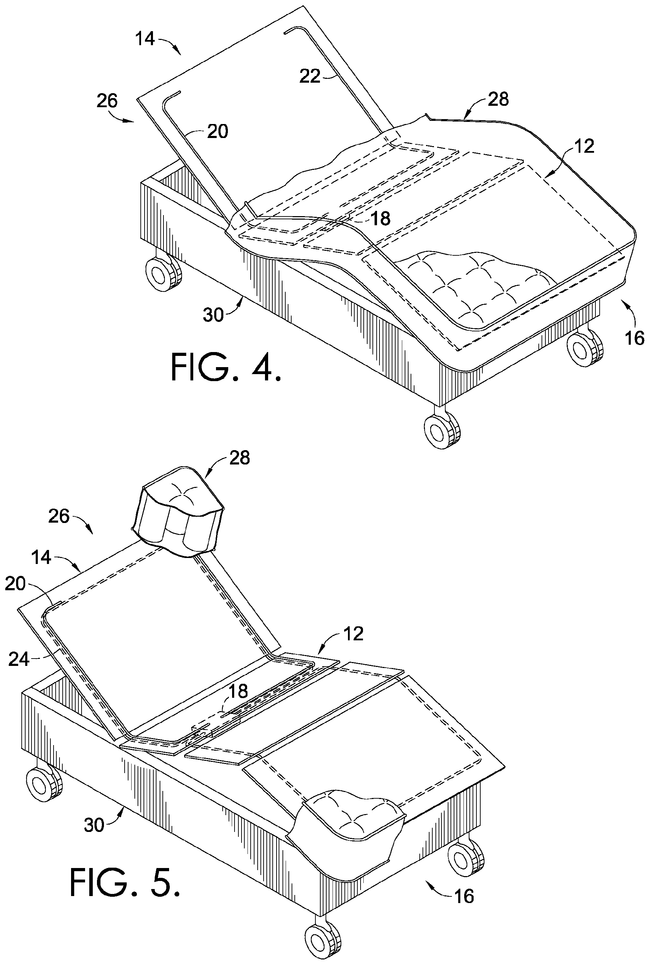

Referring next to FIG. 4, an adjustable bed 26 incorporates the automated bedding system 10 described with respect to FIGS. 1-3. The adjustable bed 26 includes a mattress 28 and a frame 30. A top portion of the mattress is cut away to reveal the first end 14 of the automated bedding system 10 platform, with the head of the bed partially raised. As described with reference to FIG. 1 , capacitive wire segments 20 and 22 provide a defined sensing area near the first end 14, which detects a change in capacitance above the bed, such as the capacitance detected from a person resting on the bed.

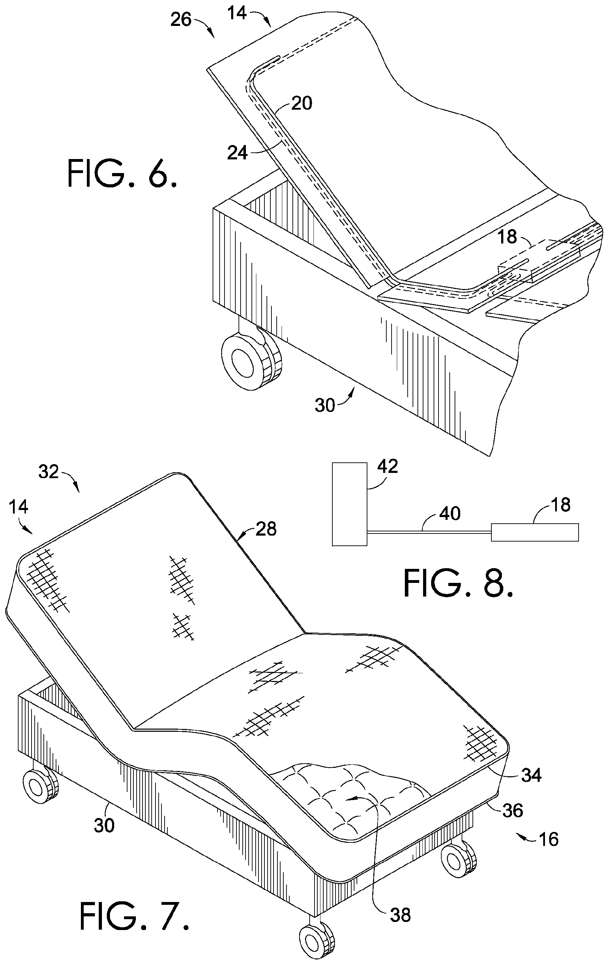

FIG. 5 depicts the adjustable bed 26 from FIG. 4, with a majority of the mattress 28 removed. As can be seen on the plurality of panels 12, first and second segments 20 and 22 of capacitive wire detect presence above the platform (e.g. on top of the mattress), while the third segment 24 detects presence below the platform (e.g. under the bed). An enlarged view of FIG. 5 is shown in FIG. 6, with hidden lines depicting capacitive wires 20 and 24 coupled to the control enclosure 18, which is mounted beneath the panels 12.

In some embodiments, in addition to positioning of capacitive wiring around the perimeter of the panels 12 that support an adjustable mattress, conductive wire is attached around the perimeter of the mattress itself. As shown in the adjustable bed 32 of FIG. 7, conductive wire may be incorporated into the tape edge surrounding the mattress 28. As such, the attached conductive wire may work as a sensor to detect presence of a person or other body near the perimeter of the mattress 28. For example, a conductive wire may be incorporated into the top tape edge 34 around the top surface of the mattress 28. In another example, a conductive wire may be incorporated into the bottom tape edge 36 around the bottom surface of the mattress 28. During manufacturing, a conductive wire may be inserted into the tape edge automatically, as the tape edge is applied to a mattress covering. In some embodiments, when routed through the tape edge perimeter, the sensitivity of the conductive wire may be adjusted in software associated with a processor used to determine presence detection.

The capacitive wire may be routed through some or all of the tape edge around the perimeter of a mattress 28. Additionally, a tape edge may be applied to both the top and bottom edges of the mattress 28, and both the top and bottom tape edges 34 and 36 may include a capacitive wire. Accordingly, the sensitivity of the capacitive wire in the top tape edge 34 may be adjusted independently from the tape edge 36 surrounding the perimeter of the bottom of the mattress. For example, a small change in voltage detected by the capacitive wires in the top tape edge 34 of the mattress may indicate that a user has moved on the surface of the mattress, but is still on the bed. By contrast, a small change in voltage detected by the capacitive wires in the bottom tape edge 36 of the mattress may indicate that a person, or other being, is below the bed. In either case, different features associated with the automated bedding system 10 may be activated based on whether presence is detected above the bed (via capacitive wires in the top tape edge 34) or below the bed (via capacitive wires in the bottom tape edge 36).

In further embodiments, a capacitive component may be incorporated into the mattress covering 38 of a mattress 28, as shown in FIG. 7. In particular, a capacitive thread may be sewn into the ticking on top of the mattress covering 38, as part of a sewn pattern. During manufacturing, a particular needle threaded with capacitive thread may be activated automatically and independently to incorporate the capacitive wire into a particular configuration on the surface of the mattress covering 38. For example, the capacitive thread may be sewn around a perimeter of the top surface of the mattress 28. In another example, the capacitive wire may be sewn in a pattern that creates perpendicular runs for capacitive detection. In one embodiment, capacitive thread sewn into the surface of a mattress covering 38 may terminate at a particular point and attach to a control enclosure 18. For example, an attachment may be used to crimp the mattress covering 38 material during sewing, to provide an attachment point for connecting the capacitive thread to a processor.

In some embodiments, a capacitive component may be incorporated into a platform-style bed. For example, a lower portion of a bed that does not articulate, such as a box spring or a mattress frame 30, may include a capacitive component that detects presence from above. In one embodiment, a capacitive wire is attached in a loop around the perimeter of the top of the frame 30, in FIG. 7. When a person or body is detected on top of the platform and/or frame 30, the articulating mattress 28 may discontinue lowering into contact with the frame 30. In one embodiment, a capacitive wire may be incorporated into the upholstery of a decorative surround (immovable frame). The sensitivity of the capacitive wire may be decreased so that direct contact is required with the edge of the surround before presence may be detected, in order to prevent false readings from a body approaching the frame and/or surround. In one embodiment, a decorative surround may include a conductive, metalized tape, such as an aluminum tape, that serves as a capacitive component for detecting presence with respect to the decorative surround. For example, a conductive metalized tape may be adhered to a perimeter of the decorative surround of an adjustable bed to determine presence near and/or on the bed, based on a change in capacitance detected by the metalized tape.

Presence may also be detected using a loop of capacitive wire incorporated inside a mattress. For example, as shown in FIG. 8, a fourth segment 40 of capacitive wire may be incorporated inside an inner spring 42, and coupled to the control enclosure 18. While only one inner spring 42 is shown, it should be understood that capacitive wire could be incorporated into one or more of the many innersprings that make up a traditional mattress. As such, the loop of capacitive wire can detect a person or object in proximity to the loop, such as a person on the mattress, above the loop of capacitive wire.

A defined sensing area is created by routing of a capacitive wire around a perimeter of an adjustable bed, in a variety of configurations such as those described above. For example, a capacitive wire routed around the perimeter of a mattress, such as in the tape edge around a perimeter of the top surface of a mattress, creates a defined sensing area on the area of the mattress surrounded by the sensing perimeter. As such, a person's presence within the sensing area may be detected by the capacitive wire, which a processor may use to determine when a person exits or enters a bed. A processor coupled to the capacitive component may be housed in a control enclosure, such as control enclosure 18. In one embodiment, the control enclosure 18 is mounted below the platform of an automated bedding system 10. In further embodiments, the control enclosure 18 is mounted generally beneath the mattress 28.

In embodiments, capacitive wire incorporated into the perimeter of a mattress is used to monitor a change in capacitance over a specified amount of time. The capacitive component (capacitive wire) is adapted to have a voltage based on proximity of an object to the capacitive component. Such voltage information is collected via the capacitive component and received by the processor, which determines when a change in voltage satisfies a threshold. Once a particular change in capacitance satisfies a threshold, a corresponding function associated with the automated bed may be initiated. In embodiments, a threshold for initiating a corresponding function includes a particular amount of change in voltage within a particular amount of time. For example, when using capacitance information to turn lights on/off, a particular amount of change in voltage may be required during a particular amount of time before satisfying the threshold indicating that a person has exited the bed (and before the lights may be turned on). Similarly, a particular threshold value of voltage change may be required by the processor, over a particular amount of time, before making a determination that a person has re-entered the bed (and before the lights can be turned off again). In embodiments, a processor continuously receives capacitance monitoring information, and monitors how quickly a change in capacitance occurs (how quickly the delta changes) to determine if a big enough change has occurred in a certain amount of time to satisfy a threshold, and trigger the corresponding function.

Based on satisfying a particular threshold, various features associated with the automated bedding system 10 may be activated and/or enabled. For example, an alarm clock may only be triggered if a person's presence is detected in the bed (i.e. if a threshold amount of change in voltage is detected during capacitance monitoring over a particular amount of time). In another example, additional bedding features may be activated based on presence detection by capacitive wires. Such additional integrated bedding features include having a massage motor activated to wake up a user. If a user is not present in the bed, and therefore not detected using the capacitive wires, the lack of presence detection will prevent the massage motor from running at a particular scheduled time.

A variety of other functions of the automated bedding system 10 may be controlled based on detection with a capacitive wire. In other words, a processor coupled to the capacitive wire may initiate a variety of functions based on received data indicating presence or lack of presence, as determined using capacitance information. Different functions may be controlled, such as stopping a bed from articulating when presence is detected beneath the bed, turning on/off lights based on a person exiting/entering a bed, and controlling other accessories or electrical/household appliances through internal circuitry associated with the processor. In one example, after presence is no longer detected in the bed (thereby indicating that a person has exited the bed) lights may be turned on. Additionally, when the person returns to the bed, the lights may turn off.

A variety of communication protocols may be used to control the variety of functions described above. For example, a two-way controller using ZigBee® wireless communication protocol may be used. In some embodiments, a two-way communication protocol intended for use in automation (similar to Bluetooth®) may be utilized. One embodiment of the invention may be controlled by an external sensor only, with all of the components necessary for the sensor that plug into an existing motor. In another embodiment, two separate microcontrollers may be used: one dedicated primarily for sensing purposes that, when it detects something, sends a signal to a secondary device/microcontroller that is programmed to initiate the corresponding response.

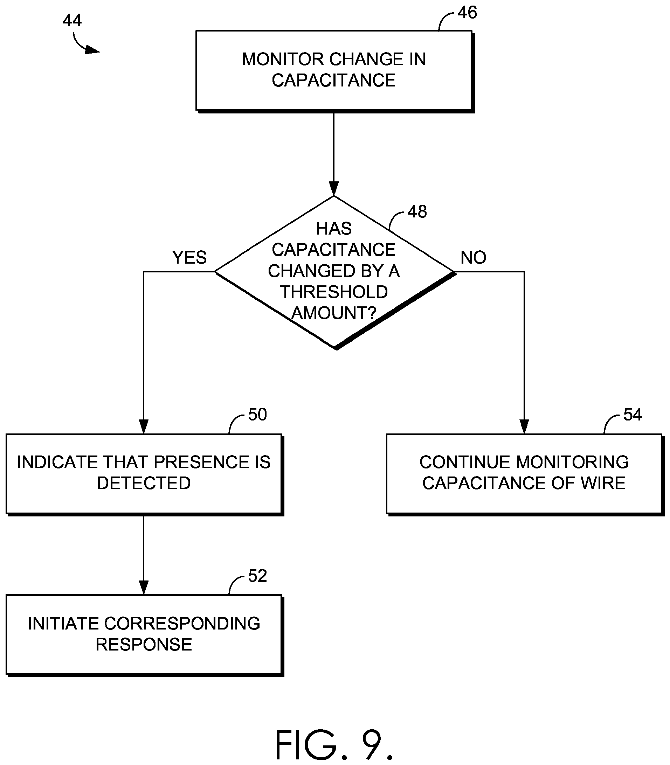

Turning now to FIG. 9, an exemplary flow diagram 44 depicts monitoring capacitance and making a determination of presence with respect to an adjustable bed. At block 46, an average change in capacitance is monitored using a capacitive wire. As discussed above, the change in capacitance indicates a change in voltage over a particular amount of time. At block 48, a determination is made regarding whether the capacitance has changed by a threshold amount. If a determination is made that the capacitance has changed by a threshold amount (i.e. a particular amount of change in voltage has occurred within a particular window of time), then an indication is made that presence has been detected at block 50, and the corresponding response is initiated at block 52. As will be understood, blocks 50 and 52 may, in some embodiments, be combined into a single step of initiation of the corresponding response based on a determination of presence detection. At block 54, if capacitance has not changed by a threshold amount, capacitance monitoring continues.

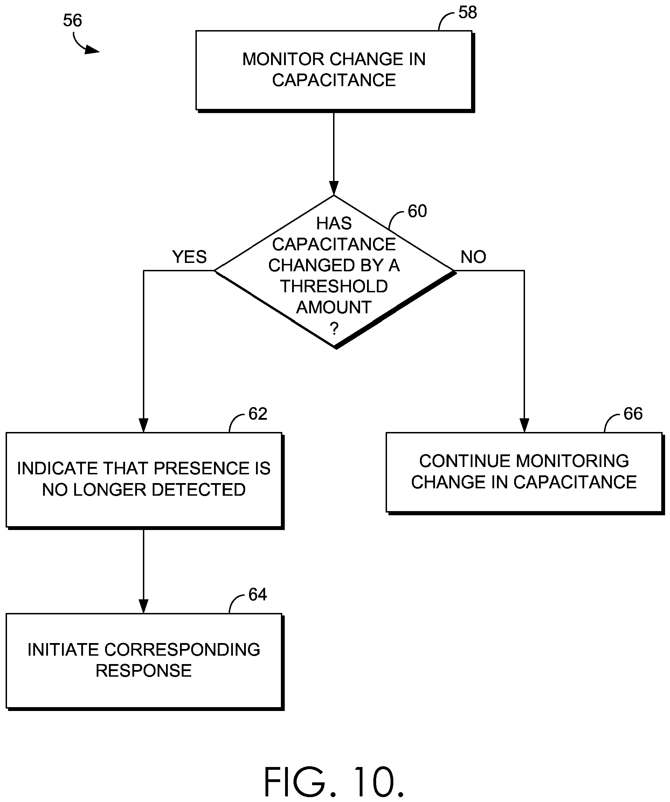

With reference next to FIG. 10, an exemplary flow diagram 56 depicts monitoring capacitance and making a determination that presence is no longer detected with respect to an adjustable bed. At block 58, an average change in capacitance is monitored using a capacitive wire. At block 60, a determination is made whether capacitance has changed by a threshold amount. At block 62, if capacitance has changed by a threshold amount, an indication that presence is no longer detected is made at block 62, and a corresponding response is initiated at block 64. At block 66, if it is determined that the threshold amount has not been satisfied, capacitance monitoring continues.

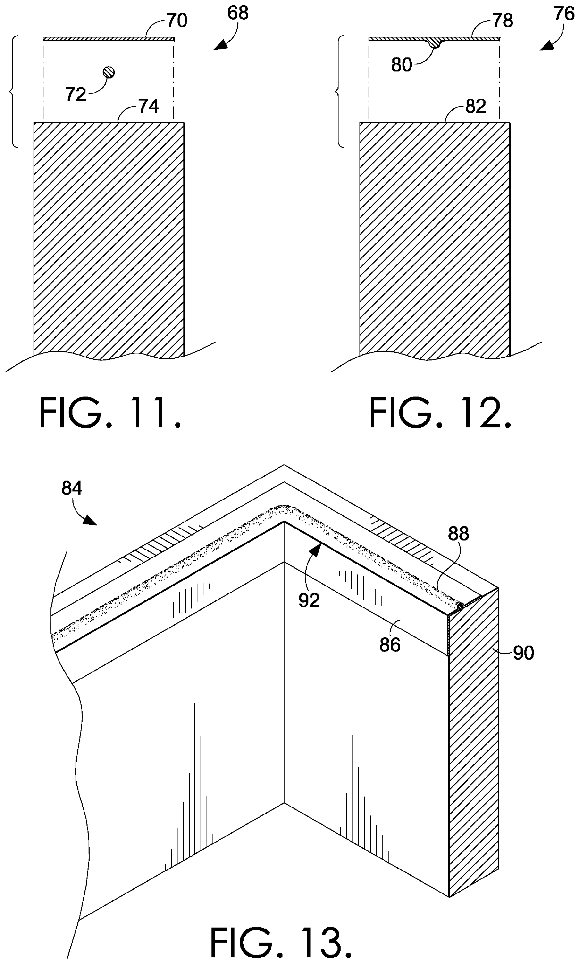

Referring now to FIG. 11 , an exemplary capacitive sensing system 68 includes a thin-gauge foil tape 70, a thin-gauge capacitive wire 72, and a substrate 74. In embodiments, foil tape 70 attaches capacitive wire 72 to a substrate 74, such as a perimeter of an adjustable bed. FIG. 12 depicts another exemplary capacitive sensing system 76, with a thin-gauge foil tape 78 having a thin-gauge, capacitive embedded wire 80, for attaching to a substrate 82. For example, a thin-gauge foil tape 78 embedded with a capacitive embedded wire 80 may be held to a substrate 82, such as an adjustable bed. In embodiments, capacitive wire 72 and/or capacitive embedded wire 80 may be coupled to substrates 74 and 82 using an adhesive portion of foil tape 70 and 78. Additionally, foil tapes 70 and 78 may be pressure sensitive adhesive (PSA) foil tapes, for attaching to substrates 74 and 82. In further embodiments, thin-gauge foil tape 70 and 78 are used to attach capacitive wire 72 and/or capacitive embedded wire 80, to a substrate. In addition or in alternative to attaching capacitive wire 72 or capacitive embedded wire 80 using foil tape, such capacitive wiring systems may be coupled to a substrate using staples, glue, adhesive, or otherwise fastened to a number of surfaces to create a capacitive circuit on the adjustable bed.

In the example of FIG. 13, a capacitive sensing system 84 includes a thin-gauge foil tape 86 with an embedded wire 88 coupled to a substrate 90. In particular, the foil tape 86 is applied to an inner edge 92 of substrate 90, such as an inner edge of an adjustable bed frame. In embodiments, foil tape 86 is a PSA tape that is adapted to adhere to a surface of substrate 90, while permitting the foil tape 86 (and the embedded wire 88) to maintain a charge during monitoring of capacitance. For example, foil tape 86 may be coupled to a controller and monitored using a software application that analyzes changes in capacitance, as detected via the foil tape 86 and the embedded wire 88. For example, foil tape 86 may be coupled to a controller (such as a microcontroller) associated with a software application, and used to capacitively detect mammalian touch with respect to an adjustable bed. In embodiments, foil tape 86 is capacitive, and is coupled to the embedded wire 88 that is electrically coupled to the microcontroller.

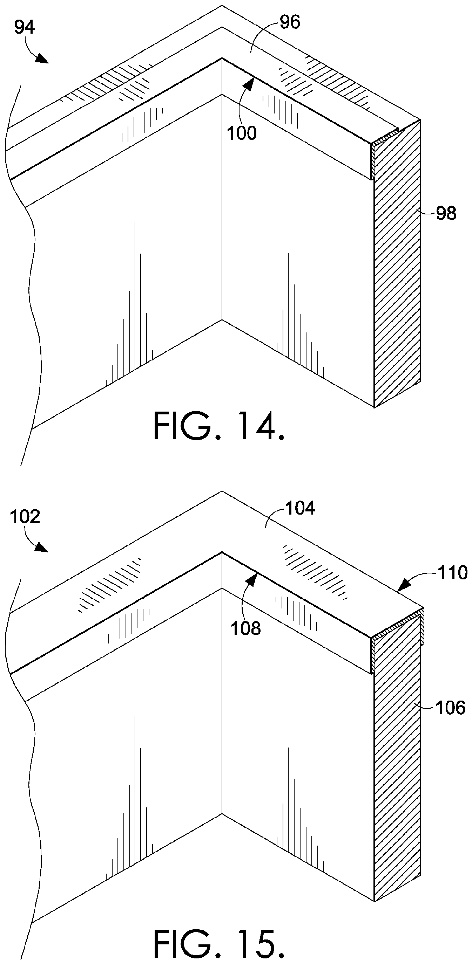

In FIG. 14, a capacitive sensing system 94 includes a capacitive cap 96 coupled to a substrate 98 along an inner edge 100. In embodiments, substrate 98 may be a frame and/or base of an adjustable bed, with an inner edge 100, on which capacitive cap 96 is applied and used for capacitive detection. In one embodiment, capacitive cap 96 is a sensing material, such as a metalized tape, that is able to detect changes in capacitance, and can be placed under or on top of fabrics. Similarly, with reference to FIG. 15, capacitive sensing system 102 depicts a capacitive cap 104 coupled to the top of substrate 106. In particular, capacitive cap 104 is applied along inner edge 108 and outer edge 110. In one embodiment, capacitive cap 104 is a foil and/or metalized tape that can detect a change in capacitance. In further embodiments, substrate 106 may be a frame and/or base of an adjustable bed, with the inner edge 108 and outer edge 110, on which capacitive cap 104 may be used to detect presence based on a change in capacitance detected by the capacitive cap 104. In some embodiments, capacitive cap 96 and/or capacitive cap 104 may be a metallic coated plastic trim that can be used as a sensing material, in addition to or in alternative to a conductive wire and/or foil tape. In further embodiments, capacitive caps 96 and 104 may be made from other ferrous or metallic shapes, such as angles, zees, tees, caps, etc. As such, in embodiments using foil tape for capacitive detection, additional metallic materials could be used to provide capacitive detection of presence with respect to an adjustable bed.

In embodiments, a thin-gauge perimeter wire may be installed around a perimeter of an adjustable bed and/or frame of an adjustable bed. In embodiments, the thin-gauge perimeter wire may be coupled to the base of an adjustable bed using tape; adhesives; fasteners; staples; or may be embedded or extruded through foam; covered in a thin foil tape; or attached via one or more additional/alternative hardware mechanisms. In one embodiment, the perimeter wire may be embedded in foil tape prior to application to the bedding device, as in the example of FIGS. 12-13. In a further embodiment, the perimeter wire may be connected to a coaxial cable using sockets, such as using an RCA jack and socket, or a mechanism such as a Molex® or an Amp connector.

In embodiments, the foil tape and the perimeter wire are capacitively coupled and sensitive to touch. That is, similar to the capacitive wire segments used to detect presence or absence of a person or other being on top of an automated bedding system, foil tape and a perimeter wire coupled to a frame or base of an adjustable bed may also be capacitively coupled and able to detect presence or absence based on a detected change in capacitance. Further, such capacitance detection may be adjusted to a required amount of sensitivity for presence detection, such as "fine tuning" the microcontroller and/or software for detection using thicker upholstery.

In a further embodiment of the invention, ports, grommets, and/or sockets are added to an automated bedding mattress construction to allow connection of a capacitive wire to spring an assembly, thereby creating a capacitive array internal to the mattress. As discussed with reference to FIG. 8, capacitive wire may be incorporated into one or more inner springs of a mattress. Further, in one example, a perimeter wire coupled to an automated bed frame may also be coupled to the inner spring of a mattress assembly to create a capacitive array that detects presence with relation to both the mattress and the frame. In some embodiments, a wire mesh, such as netting and/or a screen, may be capacitively connected to a capacitive sensing system for detection associated with the same perimeter wire.

In some embodiments, body capacitance can be used to operate different types of switches as a capacitive touch sensor will respond to close-proximity detection of a change in capacitance. Accordingly, the tip of a finger may be detected by a capacitive sensor, with a minimal amount of pressure (i.e., triggered without forceful touching), and the capacitive sensing system of an automated adjustable bed may detect minimal amounts of bodily contact.

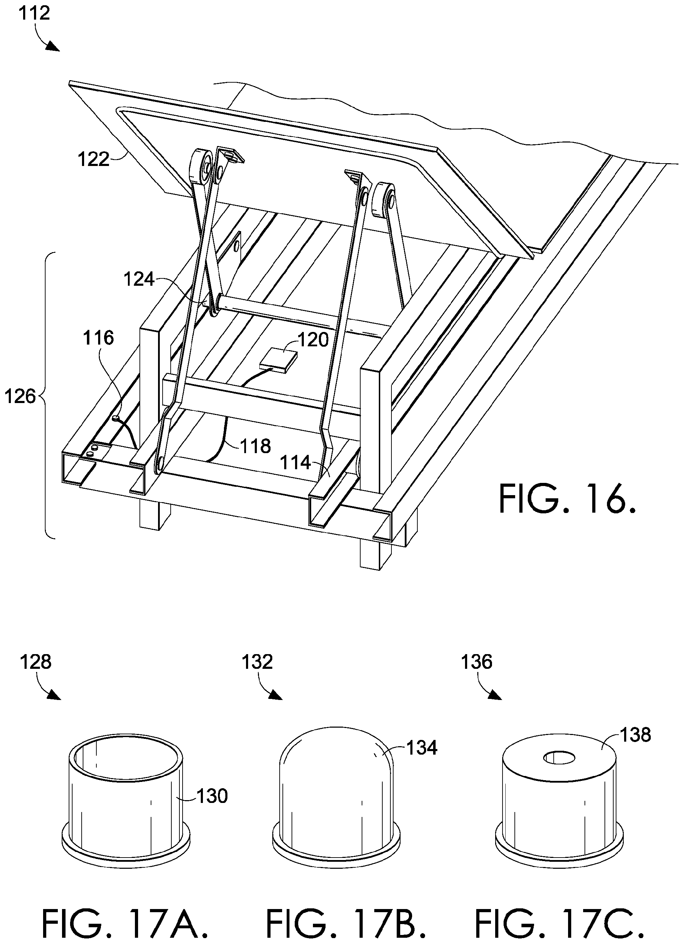

Turning next to FIG. 16, a rear-perspective view of an adjustable bed 112 includes a metal, adjustable bed frame 114 coupled at a contact point 116 to a coaxial cable (coax) 118 and a controller 120. As a portion of the adjustable bed 122 is in motion, presence near the frame 114 of the adjustable bed 122 may be detected by the controller 120, based on the capacitance monitored via bed frame 114. Accordingly, the metal, adjustable bed frame 114 is used as a sensor, with the metal being a conductive material adapted to carry a charge. In embodiments, multiple metal components 126 are coupled together to form the adjustable bed frame 114. Many of these parts are coupled together at joints 124 that are also adapted to carry a charge, which enables the controller 120 to detect presence with respect to contact with any conductive portion of the adjustable bed frame 114.

In one embodiment, when a person contacts the adjustable bed frame 114, the frame's normal capacitance is increased. In response to the increase in capacitance by contact with the bed frame 114, the controller 120 measures the change in capacitance of the bed frame 114 against a known capacitance of the frame. In embodiments, controller 120 may be mounted to the bed frame 114 directly, with a separate microcontroller for a sensor, and a separate microcontroller for controlling the bed motion. Accordingly, a sensing microcontroller may use separate channels for wire detection of presence (discussed above) and frame detection of presence. In embodiments, the use of a coax 118 to directly connect the bed frame 114 to the controller 120 reduces the amount of interference caused during monitoring and/or detection, as the coax exits the controller 120 and will not detect any signals until it reaches the bed frame 114.

In one example, as connected to the bed frame 114 via coax 118, controller 120 measures capacitance by pulsing the bed frame 114 with a voltage, such as a low voltage having a minimal amount of current. In between pulses from the controller 120, the signal fed into the controller' s analog to digital converter (ADC) is used to measure how much the voltage changes over time. In one embodiment, one microcontroller of the controller 120 may send out a charge, with the resulting charge being read by another microcontroller having a processor that monitors how quickly the detected charge decays. In one embodiment, when a body is in contact with the frame, the controller 120 monitors how quickly the change in capacitance rises, and how far the change in capacitance rises.

Based on detection of a change in capacitance by the controller 120, the actuator of the adjustable bed frame 114 may be disabled during a motion operation if it is determined that human contact is detected. In embodiments, the controller 120 may monitor the overall levels of capacitance of the bed frame 114 to determine what changes in capacitance do and do not satisfy a threshold for determining that contact has been made. For example, the rate of change and the amount of change may be monitored to determine whether a threshold for contact has been met, and whether the travel of the bed frame 114 should be altered. In embodiments, when triggered by a controller 120, the actuators of an adjustable bed 112 may be programmed to stop all motion (such as downward motion) when contact is detected by the conductive, metal bed frame 114. In such an example, when presence of a human is detected underneath a moving, adjustable bed 112, the detection by bed frame 114 may indicate to the controller 120 to discontinue travel of the bed frame 114. In another embodiment, in response to detection of a human underneath a moving, adjustable bed 114, the actuators may reverse and/or retract motion by a particular distance, such as backing up an inch if the bed frame 114 was lowering to a downward position when presence was detected.

Accordingly, to re-start travel once a condition has been met for stopping travel by the controller 120, a user may indicate to the adjustable bed 112 that 1) the condition that triggered the indication of presence has gone away, and/or 2) that the user has again selected motion of the adjustable bed frame 114 by providing an indication to the controller 120 (such as pushing a button on a controller of the adjustable bed 112). In further embodiments, controller 120 may track the usage of an adjustable bed 112, and the subsequent commands received after detecting presence near a moving bed frame 114. Such tracking may be used to designate specific actions required by the bed in response to presence detection, such as moving of a bed into a fully-upright position, or discontinuing motion of the bed prior to initiating a subsequent lowering once presence is no longer detected.

With reference to FIG. 17A, an exemplary metallic bushing 128, such as conductive bushing 130, may be used to provide an acceptable transfer of energy within the metal, adjustable bed frame 114 of FIG. 16. For example, one or more parts of an adjustable bed frame 114 may be coupled together at joints 124 that use conductive bushing 130 to carry a charge, thereby enabling a controller 120 to detect presence with respect to contact with any conductive portion of the adjustable bed frame 114. Additional embodiments of metallic bushings 132 and 136 are depicted in FIGS. 17B and 17C. FIG. 17B depicts an exemplary, conductive encapsulating torque tube 134, while FIG. 17C depicts an exemplary, conductive bushing 138 for use with capacitive detection associated with the metallic, adjustable med frame 114. Accordingly, in some embodiments, conductive bushings are made using conductive materials to create "conductive" plastics, such as using stainless steel, carbon fibers, carbon black, carbon powder, graphite, and the like. In another embodiment, conductive bushings are made using chemical additives or coatings added to plastic bushings to increase the conductivity. In further embodiments, a metal coating on the outside of a bushing, or a metal coating encapsulated inside a plastic bushing, may be used to generate conductive bushings. As will be understood, a number of metallic, conductive, and/or chemical additives, treatments or materials may be used to create conductive bushings for use in a metallic assembly that carries a charge and is used to detect capacitance with respect to the metallic, adjustable bed frame 114.

As will be understood, "traditional" bushings used in adjustable beds are often made with electrically-insulating acetals, which prevent the transfer of a charge during detection of capacitance. Accordingly, in some embodiments, parasitic capacitive coupling may be used to capacitively couple components of the adjustable bed. In a further embodiment, jumper wires are used to connect components of an adjustable bed that are electrically isolated due to nonconductive bushings. For example, electrically-isolated parts of a metal, adjustable bed frame may be coupled to other conductive portions of the bed frame using jumper wires.

In embodiments, bushings and other washer materials being carbon-fiber filled acetal with moderate surface conductivity may be used. Such bushings and washers may assist in the transfer of energy throughout a metal, adjustable bed frame 114, its components, and related assemblies. In some embodiments, a metallic bed frame may be capacitively coupled to other assemblies in the adjustable base. Accordingly, the term "metallic assembly" may be used to refer to any of the frame and components of the frame of an adjustable bed.

In one embodiment, acetal carbon-fiber filled bushings are less than or equal to the surface resistivity of 1.0E+3 ohm and have a volume resistivity of 1.0E+3 ohm centimeter (using test methods per IEC 60093). The human body capacitance is the input to the metallic assembly, and the carbon-fiber filled bushings act as "jumper wires" to transmit energy between the metallic assemblies in adjustable beds. In one embodiment, electroceramics (ceramic materials specifically formulated for electrical properties) may be tailored for use as a highly-conductive bushing material, such as the electronically conductive ceramic consisting of Indium Tin Oxide (ITO), Lamthanum-doped strontium titanate (SLT), and yttrium-doped strontium titanate (SYT).

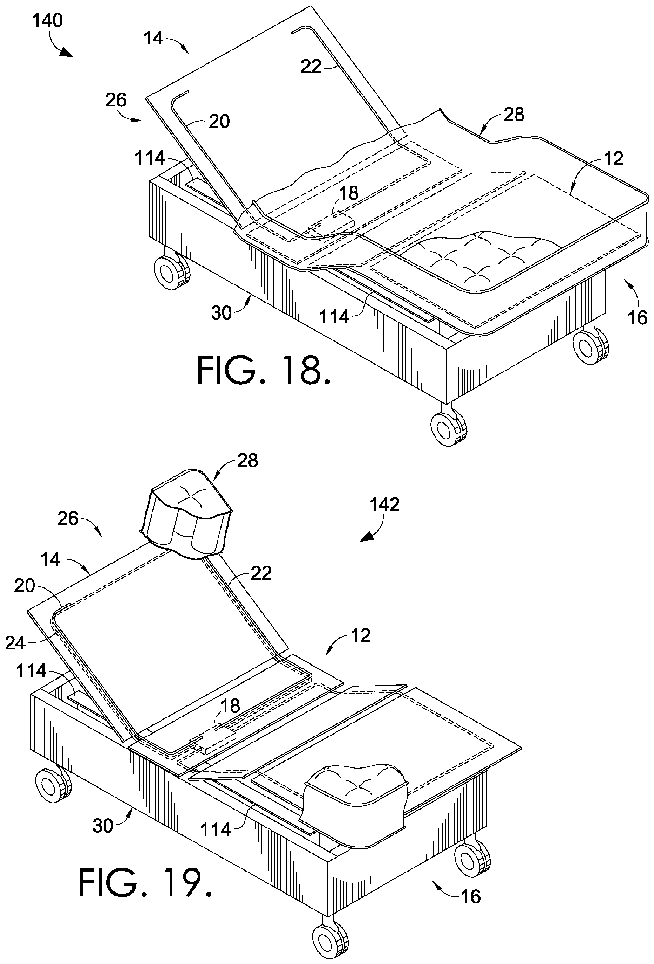

Turning next to FIG. 18, an automated bedding system 140 includes an adjustable bed 26 having a plurality of panels 12 with a first end 14 and a second end 16, a control enclosure 18 (mounted below the plurality of panels 12), a first segment 20 of a capacitive wire, and a second segment 22 of a capacitive wire. In some embodiments, the first end 14 may be referred to as the "head" of the bed, while the second end 16 may be referred to as the "foot" of the bed. In FIG. 18, adjustable bed 26 is depicted in a raised position with the first end 14 raised and the second end 16 raised, to reveal a portion of the metal, adjustable bed frame 114 of the adjustable bed 26. In embodiments, the bed frame 114 is a conductive material used to carry a charge and monitor a change in capacitance, as discussed above. Accordingly, in an example where the first end 14 of the adjustable bed 26 is being lowered, detection of human contact with the bed frame 114 may trigger the bed to discontinue downward motion. In some embodiments, detection of contact with bed frame 114 may also trigger a retracting and/or raising of the first end 14. Similarly, in another embodiment, the lowering of second end 16 may be stopped based on detection of human presence by bed frame 114.

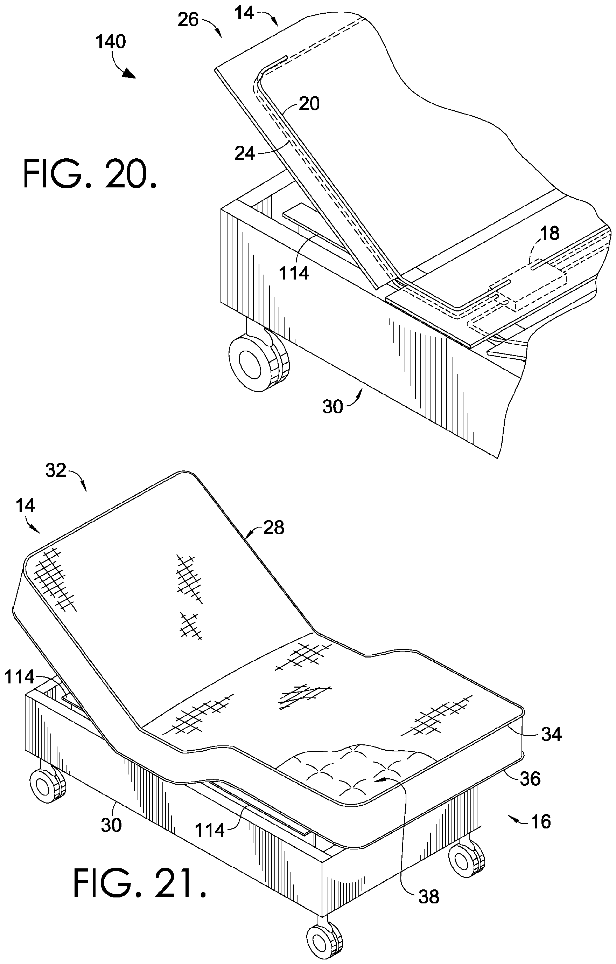

As can be seen in FIG. 18, capacitive wiring around a perimeter of a platform is used in addition to the capacitive detection using bed frame 114. Accordingly, FIG. 19 depicts the adjustable bed of FIG. 18, with a majority of the mattress 28 removed. As can be seen on the plurality of panels 12, first and second segments 20 and 22 of capacitive wire detect presence above the platform (e.g. on top of the mattress), while the third segment 24 detects presence below the platform (e.g. under the bed). An enlarged view of FIG. 19 is shown in FIG. 20, with hidden lines depicting capacitive wires 20 and 24 coupled to the control enclosure 18, which is mounted beneath the panels 12. Further, the metal frame 114 is shown below the mattress 28, and is used to detect presence, in addition to the capacitive wire segments on the platform 12.

With reference to FIG. 21, an enlarged, perspective view of the automated bed of FIG. 19, with head and feet portions of the bed raised to partially reveal a metal, adjustable bed frame 114 is shown. Additionally, in some embodiments, a conductive wire may be incorporated into the top tape edge 34 around the top surface of the mattress 28. In another example, a conductive wire may be incorporated into the bottom tape edge 36 around the bottom surface of the mattress 28. During manufacturing, a conductive wire may be inserted into the tape edge automatically, as the tape edge is applied to a mattress covering. In some embodiments, when routed through the tape edge perimeter, the sensitivity of the conductive wire may be adjusted in software associated with a processor used to determine presence detection. Accordingly, in some embodiments, presence may be detected with respect to an adjustable bed using both wiring incorporated into the perimeter of the mattress, the metal, adjustable bed frame 114 itself being used as a capacitive sensor.

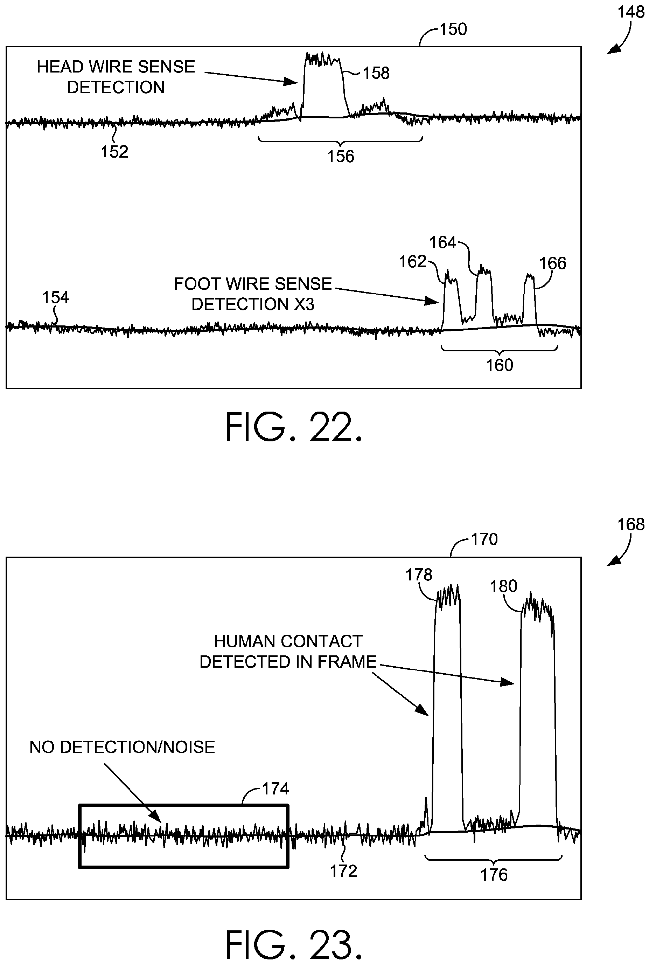

With reference to FIGS. 22-24, capacitive detection is monitored over time, noting changes in capacitance due to presence detection, noise interference, and movement of the automated bed. For example, in FIG. 22, capacitance detection 148 is shown on a display 150 that includes both head wire monitoring 152 and foot wire monitoring 154. As shown along the path of the head wire monitoring 152, head wire sense detection area 156 indicates a peak 158 of change in capacitance. Similarly, along the path of the foot wire sense monitoring 154, foot wire sense detection area 160 indicates three peaks 162, 164, and 166, that indicate changes in capacitance. Accordingly, in one embodiment, a capacitive wire near a first end 14 (head) of an adjustable bed may detect a change capacitance (such as peak 158) that triggers one or more features of the adjustable bed. In another embodiment, a capacitive wire near a second end 16 (foot) of an adjustable bed may detect a change in capacitance (such as one or more of the peaks 162, 164 and 166) and be used to trigger one or more features of an adjustable bed. In some embodiments, triggering a feature of an adjustable bed requires satisfying a threshold for detection. In other words, the monitoring system may detect changes in capacitance in relation to the head or foot portions of the bed, but the change in capacitance may not be great enough to satisfy a threshold for detection that triggers a feature. For example, minimal movement of a person on a mattress may indicate some level of change in capacitance to the monitoring system, without triggering any change in movement of the bed or activity of associated features. Meanwhile, complete removal of user from a bed, which alters the detected capacitance above a particular threshold may indeed trigger the threshold for an associated activity, such as lowering the foot of the bed and/or triggering lights to come on.

Turning next to FIG. 23, capacitance detection 168 is shown on a display 170 that includes monitoring of capacitance 172 of a metal, adjustable bed frame. Detection area 174 designates the indication of no presence being detected, and also provides an indication of the inherent level of noise that is detected by the system. Further, detection area 176 indicates peaks 178 and 180 of changes in capacitance, which exhibit that human contact with the bed frame has been detected. As discussed above, a threshold for detection may be determined, such that a minimal amount of contact, for a short period of time, may not trigger an indication of presence with respect to the bed frame. At the same time, contact with the bed frame for a longer period of time, as indicated by a large change in capacitance for a longer duration, may be associated with a determination of presence under and/or near the bed frame. In embodiments, detection of human contact with the frame, as indicated by peaks 178 and 180, may trigger a number of features associated with the adjustable bed, such as stopping of a lowering feature, alerting of an alarm feature, retracting of motion in an upward direction for a specified distance, or any combination of features programmed to activate in response to the appropriate trigger.

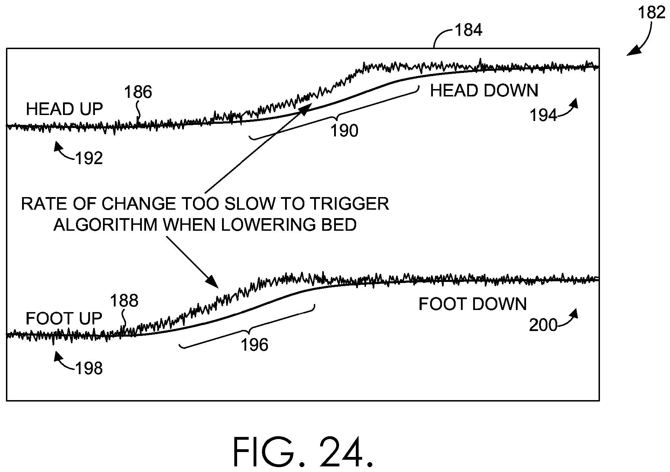

With reference finally to FIG. 24, capacitance detection 182 is shown on display 184 to demonstrate the amount of change in capacitance over time with respect to the frame of an adjustable bed, such as the adjustable bed frame monitored in FIG. 23. Display 184 includes the monitoring of a head portion 186 and a foot portion 188 of an adjustable bed. In embodiments, the rate of change area 190 is monitored as the capacitance changes from a first level of capacitance 192 to a second level of capacitance 194. Similarly, rate of change area 196 is monitored as the capacitance changes from a first level of capacitance 198 to a second level of capacitance 200. In embodiments, the rate of change in capacitance impacts whether the change itself triggers any feature of the automated bed. Accordingly, as indicated on the display 184, the rate of change area 190 and the rate of change area 196 indicate to a processor and/or controller that the rate of change in capacitance is occurring over too long of a time (i.e., is too slow) to trigger any of the features of the adjustable bed associated with lowering of the bed. For example, an algorithm that requires a minimum amount of change in capacitance before stopping lowering a bed (i.e. an algorithm that requires detection of the presence of human contact) may not be triggered by the change in capacitance caused by the movement of the bed itself, such as in FIG. 24.

As will be understood, a variety of filtering techniques may be used to adjust the determinations made (regarding whether presence is or is not detected) using software associated with the processor. For example, a variety of filters or transforms may be applied to the monitored capacitance signal to adjust/adapt the software for a particular application or user. For example, an automated bedding system could be adapted to adjust lighting or other functions based on particular amounts of change in capacitance over particular amounts of time, or trigger particular functions during particular times of day/night. As such, a processor may be trained to alter the sensitivity of a threshold based on previous use by a particular user of a corresponding feature. Additionally, a reaction time may be changed and a threshold may be adjusted for different users and different features of the automated bed.

From the foregoing, it will be seen that this invention is one well adapted to attain all the ends and objects hereinabove set forth together with other advantages, which are obvious and which are inherent to the structure.

It will be understood that certain features and subcombinations are of utility and may be employed without reference to other features and subcombinations. This is contemplated by and is within the scope of the claims.

Since many possible embodiments may be made of the invention without departing from the scope thereof as defined in the appended claims, it is to be understood that all matter herein set forth or shown in the accompanying drawings is to be interpreted as illustrative and not in a limiting sense.

## Claims

1. An adjustable bed (26; 32; 112), comprising:
a mattress support that comprises a plurality of support panels (12), at least one of said support panels (12) movable relative to the other ones of said support panels (12) to thereby adjust the bed (26; 32; 112);
a mattress (28) resting on top of the mattress support, said mattress (28) having a covering material (38) disposed over at least a top surface of the mattress (28);
at least two capacitive components (20, 22, 24; 34, 36, 38; 40; 72; 80; 88; 96; 104; 114) coupled to the bed (26; 32; 112), wherein the at least two capacitive components (20, 22, 24; 34, 36, 38; 40; 72; 80; 88; 96; 104; 114) are each adapted to have a voltage based on proximity of an object to the at least two capacitive components (20, 22, 24; 34, 36, 38; 40; 72; 80; 88; 96; 104; 114), wherein a first capacitive component of the at least two capacitive components (20, 22, 24; 34, 36, 38; 40; 72; 80; 88; 96; 104; 114) comprises a metal frame (114) associated with the adjustable bed (26; 32; 112), wherein a second capacitive component of the at least two capacitive components (20, 22, 24; 34, 36, 38; 40; 72; 80; 88; 96; 104; 114) comprises a capacitive sensor (20, 22) positioned around the perimeter of the panels (12) of the mattress support; and
wherein a processor (18) is coupled to the first and second capacitive components (20, 22, 24; 34, 36, 38; 40; 72; 80; 88; 96; 104; 114), the processor (18) adapted to receive information provided by the first and second capacitive components (20, 22, 24; 34, 36, 38; 40; 72; 80; 88; 96; 104; 114) and to determine that a respective change in voltage satisfies a respective threshold, and the processor (18) adapted to detect presence of the object underneath the panels (12) of the adjustable bed (26; 32; 112) if the change in voltage of the first capacitive component satisfies the respective threshold and to detect presence of the object above the panels (12) of the adjustable bed (26; 32; 112) if the change in voltage of the second capacitive component satisfies the respective threshold.

2. The bed (26; 32; 112) of claim 1, wherein receiving information provided by the first and second capacitive components (20, 22, 24; 34, 36, 38; 40; 72; 80; 88; 96; 104; 114) comprises pulsing the metal frame (114) with a voltage to provide a charge to the metal frame (114).

3. The bed (26; 32; 112) of claim 2, wherein an analog to digital (ADC) converter is used to measure how the charge of the metal frame (114) changes over time.

4. The bed (26; 32; 112) of any one of claims 1 to 3, wherein determining that the change in voltage satisfies the respective threshold comprises: monitoring the change in voltage detected by the first and second capacitive components (20, 22, 24; 34, 36, 38; 40; 72; 80; 88; 96; 104; 114) over a particular period of time; and comparing the change in voltage over the period of time with the respective threshold.

5. The bed (26; 32; 112) of claim 4, wherein, based on determining that the change in voltage satisfies the respective threshold, the processor (18) is adapted to discontinue motion of the adjustable bed (26; 32; 112) until it is determined that the change in voltage no longer satisfies the respective threshold.

6. The bed (26; 32; 112) of claim 4, wherein, based on determining that the change in voltage satisfies the respective threshold, the processor (18) is adapted to discontinue motion of the adjustable bed (26; 32; 112) until it is determined that an indication to initiate motion is received.

7. A method for detecting presence with respect to an adjustable bed (26; 32; 112),
the adjustable bed (26; 32; 112) comprising a mattress support that comprises a plurality of support panels (12), at least one of said support panels (12) movable relative to the other ones of said support panels (12) to thereby adjust the bed (26; 32; 112), and a mattress (28) resting on top of the mattress support, said mattress (28) having a covering material (38) disposed over at least a top surface of the mattress (28);
the method comprising:
receiving information provided by at least two capacitive components (20, 22, 24; 34, 36, 38; 40; 72; 80; 88; 96; 104; 114) coupled to the adjustable bed (26; 32; 112), wherein the at least two capacitive components (20, 22, 24; 34, 36, 38; 40; 72; 80; 88; 96; 104; 114) comprise a first capacitive component which comprises a metal frame (114) associated with the adjustable bed (26; 32; 112) and a second capacitive component which comprises a capacitive sensor (20, 22) positioned around the perimeter of the panels (12) of the mattress support, wherein receiving information comprises pulsing the metal frame (114) of the adjustable bed (26; 32; 112) with a voltage to provide a charge to the metal frame (114), and further wherein the first and second capacitive components (20, 22, 24; 34, 36, 38; 40; 72; 80; 88; 96; 104; 114) each are adapted to have a voltage based on proximity of an object to the first and second capacitive components (20, 22, 24; 34, 36, 38; 40; 72; 80; 88; 96; 104; 114); and
determining that a respective change in voltage of the first and second capacitive components (20, 22, 24; 34, 36, 38; 40; 72; 80; 88; 96; 104; 114) satisfies a respective threshold, wherein determining that the respective change in voltage satisfies the respective threshold comprises: (1) monitoring the respective change in voltage detected by the first and second capacitive components (20, 22, 24; 34, 36, 38; 40; 72; 80; 88; 96; 104; 114) over a particular period of time; and (2) comparing the respective change in voltage over the period of time with the respective threshold; and
detecting presence of the object underneath the panels (12) of the adjustable bed (26; 32; 112) if the change in voltage of the first capacitive component satisfies the respective threshold and to detect presence of the object above the panels (12) of the adjustable bed (26; 32; 112) if the change in voltage of the second capacitive component satisfies the respective threshold.

8. The method of claim 7, wherein the metal frame (114) comprises at least one conductive bushing (128; 132; 136) coupled to the metal frame (114), said at least one conductive bushing (128; 132; 136) adapted to capacitively couple two or more metal components of the metal frame (114).

9. The method of claim 8, wherein the at least one conductive bushing (128; 132; 136) comprises at least one material adapted to transfer energy between the two or more metal components, wherein the at least one material comprises one or more of stainless steel, carbon fiber, carbon black, carbon powder, and graphite.

10. The method of claim 8, wherein the at least one conductive bushing (128; 132; 136) comprises at least one plastic bushing having one or more of a chemical additive that increases conductivity and a chemical coating that increases conductivity.

11. The method of claim 8, wherein the at least one conductive bushing (128; 132; 136) comprises at least one metal coating associated with the at least one conductive bushing (128; 132; 136), wherein the at least one metal coating is applied to one or more of an outside surface of the at least one conductive bushing (128; 132; 136) and an interior surface of the at least one conductive bushing (128; 132; 136).

## Patentansprüche

1. Verstellbares Bett (26; 32; 112), umfassend:
eine Matratzenauflage, die eine Vielzahl von Halteplatten (12) umfasst, wobei mindestens eine der Halteplatten (12) relativ zu den anderen der Halteplatten (12) bewegbar ist, um dadurch das Bett (26; 32; 112) zu verstellen;
eine Matratze (28), die auf einer Oberseite der Matratzenauflage aufliegt, wobei die Matratze (28) ein Abdeckmaterial (38) aufweist, das über mindestens einer oberen Fläche der Matratze (28) angeordnet ist;
mindestens zwei kapazitive Komponenten (20, 22, 24; 34, 36, 38; 40; 72; 80; 88; 96; 104; 114), die mit dem Bett (26; 32; 112) gekoppelt sind, wobei die mindestens zwei kapazitiven Komponenten (20, 22, 24; 34, 36, 38; 40; 72; 80; 88; 96; 104; 114) jeweils so ausgelegt sind, dass sie eine Spannung aufweisen, die auf der Nähe eines Objekts zu den mindestens zwei kapazitiven Komponenten (20, 22, 24; 34, 36, 38; 40; 72; 80; 88; 96; 104; 114) basiert, wobei eine erste kapazitive Komponente der mindestens zwei kapazitiven Komponenten (20, 22, 24; 34, 36, 38; 40; 72; 80; 88; 96; 104; 114) einen Metallrahmen (114) umfasst, der dem verstellbaren Bett (26; 32; 112) zugeordnet ist, wobei eine zweite kapazitive Komponente der mindestens zwei kapazitiven Komponenten (20, 22, 24; 34, 36, 38; 40; 72; 80; 88; 96; 104; 114) einen kapazitiven Sensor (20, 22) umfasst, der um den Umfang der Platten (12) der Matratzenauflage angeordnet ist; und
wobei ein Prozessor (18) mit der ersten und der zweiten kapazitiven Komponente (20, 22, 24; 34, 36, 38; 40; 72; 80; 88; 96; 104; 114) gekoppelt ist, wobei der Prozessor (18) geeignet ist, um eine Information zu empfangen, die von der ersten und der zweiten kapazitiven Komponente (20, 22, 24; 34, 36, 38; 40; 72; 80; 88; 96; 104; 114) bereitgestellt wird, und um zu bestimmen, dass eine jeweilige Spannungsänderung einem entsprechenden Schwellenwert genügt, und der Prozessor (18) ausgestaltet ist, um eine Anwesenheit des Objekts unter den Platten (12) des verstellbaren Bettes (26; 32; 112) zu erfassen, wenn die Spannungsänderung der ersten kapazitiven Komponente dem entsprechenden Schwellenwert genügt, und eine Anwesenheit des Objekts oberhalb der Platten (12) des verstellbaren Betts (26; 32; 112) zu erfassen, wenn die Spannungsänderung der zweiten kapazitiven Komponente dem entsprechenden Schwellenwert genügt.

2. Bett (26; 32; 112) nach Anspruch 1, wobei das Empfangen einer Information, die von der ersten und der zweiten kapazitiven Komponente (20, 22, 24; 34, 36, 38; 40; 72; 80; 88; 96; 104; 114) bereitgestellt wird, ein Pulsieren des Metallrahmens (114) mit einer Spannung umfasst, um dem Metallrahmen (114) eine Ladung zuzuführen.

3. Bett (26; 32; 112) nach Anspruch 2, wobei ein Analog-Digital-Wandler (ADC) verwendet wird, um zu messen, wie sich die Ladung des Metallrahmens (114) über der Zeit ändert.

4. Bett (26; 32; 112) nach einem der Ansprüche 1 bis 3, wobei das Bestimmen, dass die Spannungsänderung dem entsprechenden Schwellenwert genügt, umfasst: Überwachen der von der ersten und der zweiten kapazitiven Komponente (20, 22, 24; 34, 36, 38; 40; 72; 80; 88; 96; 104; 114) erfassten Spannungsänderung über einer bestimmten Zeitspanne; und Vergleichen der Spannungsänderung über der Zeitspanne mit dem entsprechenden Schwellenwert.

5. Bett (26; 32; 112) nach Anspruch 4, wobei der Prozessor (18) abhängig von dem Bestimmen, dass die Spannungsänderung dem entsprechenden Schwellenwert genügt, ausgestaltet ist, um eine Bewegung des verstellbaren Bettes (26; 32; 112) zu unterbrechen, bis bestimmt wird, dass die Spannungsänderung dem entsprechenden Schwellenwert nicht mehr genügt.

6. Bett (26; 32; 112) nach Anspruch 4, wobei der Prozessor (18) abhängig von dem Bestimmen, dass die Spannungsänderung dem entsprechenden Schwellenwert genügt, ausgestaltet ist, um eine Bewegung des verstellbaren Bettes (26; 32; 112) zu unterbrechen, bis bestimmt wird, dass ein Hinweis zum Einleiten einer Bewegung empfangen wird.

7. Verfahren zum Erfassen einer Anwesenheit in Bezug auf ein verstellbares Bett (26; 32; 112),
wobei das verstellbare Bett (26; 32; 112) umfasst eine Matratzenauflage, die eine Vielzahl von Halteplatten (12) umfasst, wobei mindestens eine der Halteplatten (12) relativ zu den anderen der Halteplatten (12) bewegbar ist, um dadurch das Bett (26; 32; 112) zu verstellen, und eine Matratze (28), die oben auf der Matratzenauflage aufliegt, wobei die Matratze (28) ein Abdeckmaterial (38) aufweist, das über mindestens einer oberen Fläche der Matratze (28) angeordnet ist;
wobei das Verfahren umfasst:
Empfangen einer Information, die von mindestens zwei kapazitiven Komponenten (20, 22, 24; 34, 36, 38; 40; 72; 80; 88; 96; 104; 114) bereitgestellt wird, die mit dem verstellbaren Bett (26; 32; 112) gekoppelt sind, wobei die mindestens zwei kapazitiven Komponenten (20, 22, 24; 34, 36, 38; 40; 72; 80; 88; 96; 104; 114) eine erste kapazitive Komponente, die einen dem verstellbaren Bett (26; 32; 112) zugeordneten Metallrahmen (114) umfasst, und eine zweite kapazitive Komponente umfassen, die einen kapazitiven Sensor (20, 22) umfasst, der um den Umfang der Platten (12) der Matratzenauflage positioniert ist, wobei das Empfangen einer Information ein Pulsieren des Metallrahmens (114) des verstellbaren Bettes (26; 32; 112) mit einer Spannung umfasst, um dem Metallrahmen (114) eine Ladung bereitzustellen, und wobei darüber hinaus die erste und die zweite kapazitive Komponente (20, 22, 24; 34, 36, 38; 40; 72; 80; 88; 96; 104; 114) jeweils so ausgestaltet sind, dass sie eine Spannung aufweisen, die von der Nähe eines Objekts zu der ersten und der zweiten kapazitiven Komponente (20, 22, 24; 34, 36, 38; 40; 72; 80; 88; 96; 104; 114) abhängt; und
Bestimmen, dass eine jeweilige Spannungsänderung der ersten und der zweiten kapazitiven Komponente (20, 22, 24; 34, 36, 38; 40; 72; 80; 88; 96; 104; 114) einem entsprechenden Schwellenwert genügt, wobei das Bestimmen, dass die jeweilige Spannungsänderung dem entsprechenden Schwellenwert genügt, umfasst: (1) Überwachen der jeweiligen Spannungsänderung, die von der ersten und der zweiten kapazitiven Komponente (20, 22, 24; 34, 36, 38; 40; 72; 80; 88; 96; 104; 114) erfasst wird, über eine bestimmte Zeitspanne; und (2) Vergleichen der jeweiligen Spannungsänderung über der Zeitspanne mit dem entsprechenden Schwellenwert; und
Erfassen eines Vorhandenseins des Objekts unterhalb der Platten (12) des verstellbaren Betts (26; 32; 112), wenn die Änderung der Spannung der ersten kapazitiven Komponente dem entsprechenden Schwellenwert genügt, und um ein Vorhandensein des Objekts oberhalb der Platten (12) des verstellbaren Betts (26; 32; 112) zu erfassen, wenn die Änderung der Spannung der zweiten kapazitiven Komponente dem entsprechenden Schwellenwert genügt.

8. Verfahren nach Anspruch 7, wobei der Metallrahmen (114) mindestens eine leitende Buchse (128; 132; 136) umfasst, die mit dem Metallrahmen (114) gekoppelt ist, wobei die mindestens eine leitende Buchse (128; 132; 136) dazu geeignet ist, um zwei oder mehr Metallkomponenten des Metallrahmens (114) kapazitiv zu koppeln.

9. Verfahren nach Anspruch 8, wobei die mindestens eine leitende Buchse (128; 132; 136) mindestens ein Material umfasst, das ausgestaltet ist, um Energie zwischen den zwei oder mehr Metallkomponenten zu übertragen, wobei das mindestens eine Material eines oder mehreres aus Edelstahl, Kohlenstofffaser, Ruß, Kohlenstoffpulver und Graphit umfasst.

10. Verfahren nach Anspruch 8, wobei die mindestens eine leitfähige Buchse (128; 132; 136) mindestens eine Kunststoffbuchse umfasst, die einen chemischen Zusatzstoff, der die Leitfähigkeit erhöht, und/oder eine chemische Beschichtung, die die Leitfähigkeit erhöht, aufweist.

11. Verfahren nach Anspruch 8, wobei die mindestens eine leitfähige Buchse (128; 132; 136) mindestens eine Metallbeschichtung umfasst, die der mindestens einen leitfähigen Buchse (128; 132; 136) zugeordnet ist, wobei die mindestens eine Metallbeschichtung auf eine Außenfläche der mindestens einen leitfähigen Buchse (128; 132; 136) und/oder auf eine Innenfläche der mindestens einen leitfähigen Buchse (128; 132; 136) aufgebracht wird.

## Revendications

1. Lit réglable (26 ; 32 ; 112), comprenant :
un support de matelas qui comprend une pluralité de panneaux de support (12), au moins l'un desdits panneaux de support (12) étant mobile par rapport aux autres desdits panneaux de support (12) pour ainsi régler le lit (26 ; 32 ; 112) ;
un matelas (28) reposant sur le dessus du support de matelas, ledit matelas (28) présentant un matériau de recouvrement (38) disposé sur au moins une surface supérieure du matelas (28) ;
au moins deux composants capacitifs (20, 22, 24 ; 34, 36, 38 ; 40 ; 72 ; 80 ; 88 ; 96 ; 104 ; 114) couplés au lit (26 ; 32 ; 112), dans lequel les au moins deux composants capacitifs (20, 22, 24 ; 34, 36, 38 ; 40 ; 72 ; 80 ; 88 ; 96 ; 104 ; 114) sont chacun adaptés pour présenter une tension basée sur la proximité d'un objet par rapport aux au moins deux composants capacitifs (20, 22, 24 ; 34, 36, 38 ; 40 ; 72 ; 80 ; 88 ; 96 ; 104 ; 114), dans lequel un premier composant capacitif des au moins deux composants capacitifs (20, 22, 24 ; 34, 36, 38 ; 40 ; 72 ; 80 ; 88 ; 96 ; 104 ; 114) comprend un cadre métallique (114) associé au lit réglable (26 ; 32 ; 112), dans lequel un second composant capacitif des au moins deux composants capacitifs (20, 22, 24 ; 34, 36, 38 ; 40 ; 72 ; 80 ; 88 ; 96 ; 104 ; 114) comprend un capteur capacitif (20, 22) positionné autour du périmètre des panneaux (12) du support de matelas ; et
dans lequel un processeur (18) est couplé aux premier et second composants capacitifs (20, 22, 24 ; 34, 36, 38 ; 40 ; 72 ; 80 ; 88 ; 96 ; 104 ; 114), le processeur (18) étant adapté pour recevoir des informations fournies par les premier et second composants capacitifs (20, 22, 24 ; 34, 36, 38 ; 40 ; 72 ; 80 ; 88 ; 96 ; 104 ; 114) et pour déterminer qu'un changement respectif de tension satisfait un seuil respectif, et le processeur (18) étant adapté pour détecter la présence de l'objet au-dessous des panneaux (12) du lit réglable (26 ; 32 ; 112) si le changement de tension du premier composant capacitif satisfait le seuil respectif et pour détecter la présence de l'objet au-dessus des panneaux (12) du lit réglable (26 ; 32 ; 112) si le changement de tension du second composant capacitif satisfait le seuil respectif.

2. Lit (26 ; 32 ; 112) selon la revendication 1, dans lequel la réception d'informations fournies par les premier et second composants capacitifs (20, 22, 24 ; 34, 36, 38 ; 40 ; 72 ; 80 ; 88 ; 96 ; 104 ; 114) comprend l'envoi d'impulsions dans le cadre métallique (114) avec une tension pour fournir une charge au cadre métallique (114).

3. Lit (26 ; 32 ; 112) selon la revendication 2, dans lequel un convertisseur analogique-numérique (CAN) est utilisé pour mesurer comment la charge du cadre métallique (114) change au cours du temps.

4. Lit (26 ; 32 ; 112) selon l'une quelconque des revendications 1 à 3, dans lequel la détermination que le changement de tension satisfait le seuil respectif comprend : la surveillance du changement de tension détecté par les premier et second composants capacitifs (20, 22, 24 ; 34, 36, 38 ; 40 ; 72 ; 80 ; 88 ; 96 ; 104 ; 114) sur une période de temps particulière ; et la comparaison du changement de tension sur la période de temps au seuil respectif.

5. Lit (26 ; 32 ; 112) selon la revendication 4, dans lequel, sur la base de la détermination que le changement de tension satisfait le seuil respectif, le processeur (18) est adapté pour interrompre le mouvement du lit réglable (26 ; 32 ; 112) jusqu'à ce qu'il soit déterminé que le changement de tension ne satisfait plus le seuil respectif.

6. Lit (26 ; 32 ; 112) selon la revendication 4, dans lequel, sur la base de la détermination que le changement de tension satisfait le seuil respectif, le processeur (18) est adapté pour interrompre le mouvement du lit réglable (26 ; 32 ; 112) jusqu'à ce qu'il soit déterminé qu'une indication pour initier un mouvement est reçue.

7. Procédé de détection de présence par rapport à un lit réglable (26 ; 32 ; 112),
le lit réglable (26 ; 32 ; 112) comprenant un support de matelas qui comprend une pluralité de panneaux de support (12), au moins l'un desdits panneaux de support (12) étant mobile par rapport aux autres desdits panneaux de support (12) pour ainsi régler le lit (26 ; 32 ; 112), et un matelas (28) reposant sur le dessus du support de matelas, ledit matelas (28) présentant un matériau de recouvrement (38) disposé sur au moins une surface supérieure du matelas (28) ;
le procédé comprenant :
la réception d'informations fournies par au moins deux composants capacitifs (20, 22, 24 ; 34, 36, 38 ; 40 ; 72 ; 80 ; 88 ; 96 ; 104 ; 114) couplés au lit réglable (26 ; 32 ; 112), dans lequel les au moins deux composants capacitifs (20, 22, 24 ; 34, 36, 38 ; 40 ; 72 ; 80 ; 88 ; 96 ; 104 ; 114) comprennent un premier composant capacitif qui comprend un cadre métallique (114) associé au lit réglable (26 ; 32 ; 112) et un second composant capacitif qui comprend un capteur capacitif (20, 22) positionné autour du périmètre des panneaux (12) du support de matelas, dans lequel la réception d'informations comprend l'envoi d'impulsions dans le cadre métallique (114) du lit réglable (26 ; 32 ; 112) avec une tension pour fournir une charge au cadre métallique (114), et en outre dans lequel les premier et second composants capacitifs (20, 22, 24 ; 34, 36, 38 ; 40 ; 72 ; 80 ; 88 ; 96 ; 104 ; 114) sont chacun adaptés pour présenter une tension basée sur la proximité d'un objet par rapport aux premier et second composants capacitifs (20, 22, 24 ; 34, 36, 38 ; 40 ; 72 ; 80 ; 88 ; 96 ; 104 ; 114) ; et
la détermination qu'un changement respectif de tension des premier et second composants capacitifs (20, 22, 24 ; 34, 36, 38 ; 40 ; 72 ; 80 ; 88 ; 96 ; 104 ; 114) satisfait un seuil respectif, dans lequel la détermination que le changement respectif de tension satisfait le seuil respectif comprend : (1) la surveillance du changement respectif de tension détecté par les premier et second composants capacitifs (20, 22, 24 ; 34, 36, 38 ; 40 ; 72 ; 80 ; 88 ; 96 ; 104 ; 114) sur une période de temps particulière; et (2) la comparaison du changement respectif de tension sur la période de temps au seuil respectif ; et
la détection de la présence de l'objet au-dessous des panneaux (12) du lit réglable (26 ; 32 ; 112) si le changement de tension du premier composant capacitif satisfait le seuil respectif et la détection de la présence de l'objet au-dessus des panneaux (12) du lit réglable (26 ; 32 ; 112) si le changement de tension du second composant capacitif satisfait le seuil respectif.

8. Procédé selon la revendication 7, dans lequel le cadre métallique (114) comprend au moins une douille conductrice (128 ; 132 ; 136) couplée au cadre métallique (114), ladite au moins une douille conductrice (128 ; 132 ; 136) étant adaptée pour coupler de manière capacitive deux composants métalliques ou plus du cadre métallique (114).

9. Procédé selon la revendication 8, dans lequel la au moins une douille conductrice (128 ; 132 ; 136) comprend au moins un matériau adapté pour transférer de l'énergie entre les deux composants métalliques ou plus, dans lequel le au moins un matériau comprend un ou plusieurs parmi un acier inoxydable, une fibre de carbone, un noir de carbone, une poudre de carbone, et un graphite.

10. Procédé selon la revendication 8, dans lequel la au moins une douille conductrice (128 ; 132 ; 136) comprend au moins une douille en plastique présentant un ou plusieurs parmi un additif chimique qui augmente la conductivité et un revêtement chimique qui augmente la conductivité.

11. Procédé selon la revendication 8, dans lequel la au moins une douille conductrice (128 ; 132 ; 136) comprend au moins un revêtement métallique associé à la au moins une douille conductrice (128 ; 132 ; 136), dans laquelle le au moins un revêtement métallique est appliqué sur une ou plusieurs parmi une surface externe de la au moins une douille conductrice (128 ; 132 ; 136) et une surface interne de la au moins une douille conductrice (128 ; 132 ; 136).
